# EUROPEAN PATENT SPECIFICATION

(11) **EP 2 916 171 B1**
(45) Date of publication and mention of the grant of the patent: **31.05.2017**
(21) Application number: 14157469.9
(22) Date of filing: 03.03.2014
(51) Int. Cl.: G03F 7/11, G03F 7/095, G03F 7/09, G03F 7/033

(54) **A method for making a lithographic printing plate precursor**
Verfahren zum Herstellen eines Lithographiedruckformvorläufers
Procédé pour réaliser un précurseur de plaque d'impression lithographique

(43) Date of publication of application: 09.09.2015
(73) Proprietor: AGFA GRAPHICS NV, 2640 Mortsel (BE)
(72) Inventor: Steenackers, Marin, 2640 Mortsel (BE); Loccufier, Johan, 2640 Mortsel (BE); Verbrugghe, Sam, 2640 Mortsel (BE)

(56) References cited:
- WO-A1-2007/057348
- WO-A1-2009/073098
- WO-A1-2013/129127
- JP-A- 2001 075 277
- JP-A- 2006 259 117
- JP-A- 2007 269 886

## Description

### FIELD OF THE INVENTION

The present invention relates to a method for making a negative-working lithographic printing plate precursor.

### BACKGROUND OF THE INVENTION

Lithographic printing presses use a so-called printing master such as a printing plate which is mounted on a cylinder of the printing press. The master carries a lithographic image on its surface and a print is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

The so-called "analogue" printing plates are generally obtained by first applying a so-called computer-to-film (CtF) method, wherein various pre-press steps such as typeface selection, scanning, color separation, screening, trapping, layout and imposition are accomplished digitally and each color selection is transferred to graphic arts film using an imagesetter. After processing, the film can be used as a mask for the exposure of an imaging material called plate precursor and after plate processing, a printing plate is obtained which can be used as a master. Since about 1995, the so-called "computer-to-plate" (CtP) method has gained a lot of interest. This method, also called "direct-to-plate", bypasses the creation of film because the digital document is transferred directly to a printing plate precursor by means of a platesetter. A printing plate precursor for CtP is often called a digital plate.

The support of the lithographic printing plates are typically aluminum supports which have a hydrophilic surface or on which a hydrophilic layer has been provided. This hydrophilic surface and/or layer should improve the water acceptance of the non-printing areas of a lithographic printing plate and the repulsion of the printing ink in these areas. During developing the soluble portions of the coating should be easily removed whereby the surface of the support remains residue-free so that clean background areas are obtained during printing.

Digital plates can roughly be divided in three categories:
(i) silver plates, working according to the silver salt diffusion transfer mechanism; (ii) photopolymer plates containing a photopolymerisable composition that hardens upon exposure to light and (iii) thermal plates of which the imaging mechanism is triggered by heat or by light-to-heat conversion.

Photopolymer printing plates rely on a working-mechanism whereby the coating - which typically includes free radically polymerisable compounds - hardens upon exposure. "Hardens" means that the coating becomes insoluble or non-dispersible in the developing solution and may be achieved through polymerization and/or crosslinking of the photosensitive coating upon exposure to light. Photopolymer plate precursors can be sensitized to blue, green or red light i.e. wavelengths ranging between 450 and 750 nm, to violet light i.e. wavelengths ranging between 350 and 450 nm or to infrared light i.e. wavelengths ranging between 750 and 1500 nm. Optionally, the exposure step is followed by a heating step to enhance or to speed-up the polymerization and/or crosslinking reaction. The presslife of photopolymer plates is related to the cohesive strength within the polymerized photolayer. The higher the cohesive strength, the higher the presslife. The cohesive strength can preferably be improved by increasing the crosslinking degree and/or by supramolecular non-covalent interactions such as H-bonding, Van der Waals interaction and dipole-dipole interactions.

In general, a toplayer or protective overcoat layer over the imageable layer is required to act as an oxygen barrier to provide the desired sensitivity to the plate. A toplayer typically includes water-soluble or water-swellable polymers such as for example polyvinylalcohol. Besides acting as barrier for oxygen, the toplayer should best be easily removable during processing and be sufficiently transparent for actinic radiation, e.g. from 300 to 450 nm or from 450 to 750 nm or from 750 to 1500 nm.

The classical workflow of photopolymer plates involves first an exposure step of the photopolymer printing plate precursor in a violet or infrared platesetter, followed by an optional pre-heat step, a wash step of the protective overcoat layer, an alkaline developing step, and a rinse and gum step.

JP 2007-269886 discloses an alkali soluble photosensitive composition including a polymer containing a sulfhydryl group for improving the sensitivity of the composition. JP 2005-091618 discloses an alkali soluble polymerisable composition comprising a compound containing a double bond and an alkali soluble group selected from -SH, -ArOH and -C(=X)CHZC(=Y)-R. JP 2001-075277 discloses an alkali soluble photosensitive composition consisting of a polymer having a heterocyclic group and a mercapto substituent, and a photo-acid generating agent. JP 2006-259117 discloses an alkali soluble photosensitive composition including a compound having an unsaturated double bond and a mercapto compound.Furthermore, reference can be made to WO 2009/073098 A1, which discloses an imageable element comprising a substrate having an imageable layer containing water-insoluble and alkaline solution-soluble phenolic polymer components having 1H-tetrazole groups, but not having a thio-linking group. The printing plate making method includes an optional conventional gumming step.

Over the past years, there is a clear evolution in the direction of a simplified workflow where the pre-heat step and/or wash step are eliminated and where the processing and gumming step are carried out in one single step. However, development of photopolymer plates with a so-called development/gumming solution which typically has a lower pH than the conventional alkaline developer solution, becomes much more critical. Indeed, photopolymer plates generally include rather hydrophobic monomers and/or polymeric binders in order to obtain sufficient lithographic latitude on press. Sufficient lithographic latitude on press means that the plate maintains a clear differentiation in ink acceptance between image and non-image areas upon printing. However, due to the limited solubility of these hydrophobic components in a gum solution, considerable amounts of surfactant are needed to disperse these hydrophobic compounds in the gum solution. This often leads to an unacceptable increase in viscosity of the gum solution causing plate skewing and the formation of a thick gum layer on the plate. Decreasing the amount of surfactant results in an unacceptable formation of sludge in the batch processor, speckles on the plate and deposits in the clean-out unit, and this already at a low exhaustion level. Although the use of more hydrophilic monomers or polymeric binders in the coating of the photopolymer plate improves the gum processability and exhaustion behaviour of the plate, it also results in an unacceptable blinding on press, i.e. reduced ink acceptance in the image areas during printing. In addition, more hydrophilic monomers or polymeric binders bearing an acid group, may result, due to interaction with the aluminum support, in staining (i.e. ink acceptance in the non-image areas) and/or insufficient clean-out of the non-image areas, even after printing a high number of sheets. In conclusion, there is an urgent need for polymeric binders in negative-working photosensitive lithographic printing plates which provide both a good lithographic latitude on press and an enhanced processability under non-aggressive conditions such as processing without the presence of a strong alkaline (i.e. pH ≥ 12) solution, and which minimise or even avoid the formation of sludge and precipitate and/or deposit materials in the developer solution during processing.

### SUMMARY OF THE INVENTION

It is an object of the present invention to provide a method for making a negative-working lithographic printing plate including a photopolymerisable layer which provides an excellent lithographic latitude on press combined with an improved gum processability whereby during the gum processing step the formation of organic sludge and precipitate and/or deposit materials in the developer solution is minimised or even avoided.

This object is realized by claim 1, having the specific feature that the photopolymerisable layer comprises a compound according to Formula (I) and/or Formula (II): 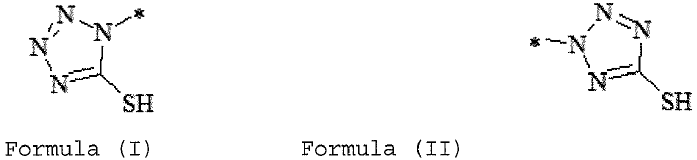 wherein *denotes the linking positions to the rest of the compound.

It was surprisingly found that a printing plate including in its coating a compound according to Formula (I) or Formula (II), is characterised by both an improved press behaviour and an improved solubility of the coating into a gum developer solution. The press behaviour or lithographic latitude on press is determined in terms of blinding and the occurrence of stain in the non-image areas. Blinding is defined as the reduction or even loss of the ink acceptance in the image areas during printing, and staining is defined as the occurance of unwanted ink acceptance in the non-image areas.

Other features, elements, steps, characteristics and advantages of the present invention will become more apparent from the following detailed description of preferred embodiments of the present invention. Specific embodiments of the invention are also defined in the dependent claims.

### DETAILED DESCRIPTION OF THE INVENTION

The lithographic printing plate precursor used in the present invention is negative-working and includes a compound according to Formula (I) and/or Formula II: 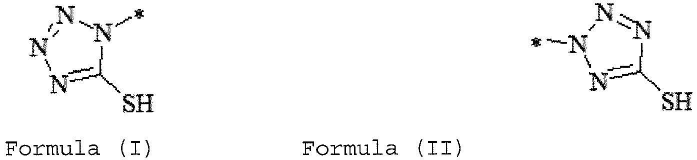 wherein *denotes the linking positions to the rest of the compound.

In a preferred embodiment, the lithographic printing plate precursor used in the present invention includes a monomer according to Formula (III) - further also referred to as "the monomer including a mercaptotetrazole group": 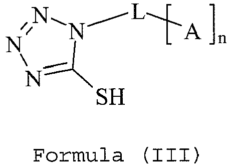 wherein
L represents a divalent, trivalent, tetravalent, pentavalent or hexavalent linking group;
A represents an ethylenically unsaturated group; and
n represents 1, 2, 3, 4 or 5 respectively for a divalent, trivalent, tetravalent, pentavalent or hexavalent linking group L.

The mercaptotetrazole group preferably has a pKa below 7, more preferably below 4, most preferably it has a pKa around 3.5, and is therefore in the anionic form in a gum developer which makes the compound according to Formula (I) or (II), or the monomer according to Formula (III) compatible with the gum developer. It was surprisingly found that a compound according to Formula (I) or (II), or a monomer according to Formula (III) in a coating of a printing plate results in a plate having a good gum processability - defined as the capability of the gum solution to disperse the detached non-image areas without forming speckels - as well as a good lithographic latitude on press i.e. no blinding and no staining. The absence of staining indicates that the mercaptotetrazole group has a limited reactivity towards the aluminum oxide surface of the support. Furthermore, it is believed that the acid mercaptotetrazole group, which is highly reactive towards radicals through hydrogen transfer reactions, will during the image-wise exposure step be built in into the polymeric network of the photolayer by a transfer-reinitiation-mechanism. More detials can be found in for example J. Pol. Sci. A Pol. Chem. 45, 2494-2502, 2007 and Polymer Handbook 4th Ed. As a result, in the exposed areas, the acid -S-H group of the mercaptotetrazole monomer may react to a non-acidic group whereby its polarity is switched from hydrophilic to more hydrophobic. In the non-exposed areas, the -S-H groups remain unreacted and contribute to an improved solubility in the gum developer solution. Hydrogen transfer during photocuring and/or the transfer-reinitiation-mechanism can for example be exemplified by the following sheme:

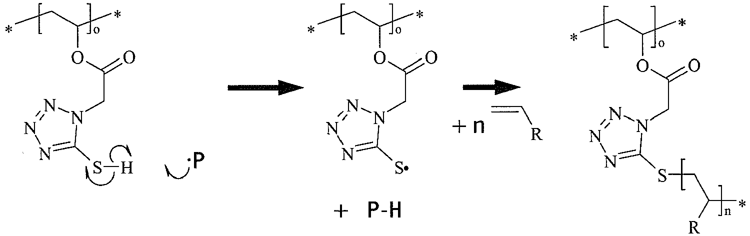

The monomer including a mercaptotetrazole group includes at least one, two, three, four or five ethylenically unsaturated group(s). The ethylenically unsaturated groups present in the monomer used in the present invention may be the same or different groups; preferably, they are the same groups. Preferably, the monomer including a mercaptotetrazole group includes one ethylenically unsaturated group. The ethylenically unsaturated group preferably represents an optionally substituted acrylate, methacrylate, acrylamide, methacrylamide, styrene, maleate, fumarate, itaconate, vinyl ether, vinyl ester, allyl ether and allyl ester group. More preferably, the ethylenically unsaturated group represents an optionally substituted acrylate, methacrylate, acrylamide, methacrylamide and/or a vinyl ether group. In a highly preferred embodiment, the ethylenically unsaturated group represents acrylamide, methacrylamide or a vinyl ester group. The optional substituents may represent a halogen such as a fluoro, chloro, bromo or iodo atom or an alkyl group such as a methyl, ethyl, propyl or isopropyl group.

The linking group L may be divalent, trivalent, tetravalent, pentavalent or hexavalent and contains at least one carbon atom. The linking group is preferably selected from an optionally substituted alkylene, arylene, or heteroarylene, -O-, -CO-, -CO-O-, -CO-NH-, -C<, >C<, -NH-CO-O-, -NH-CO-NH-, -NH-CS-NH-, -CO-NR^{'}-, -(CH₂-CH₂-O)ₑ-, -NH-CS-NH-, -SO-, -SO₂-, -SO₂-NH-, -CH=N-, -NH-NH-, -N⁺(CH₃)₂-, -S-, -S-S-, and/or combinations thereof, wherein e represents an integer greater than 1, preferably an integer ranging between 2 and 100, more preferably an integer ranging between 4 and 40, and wherein R' represents an optionally substituted alkylene, arylene, or heteroarylene. The optional substituents may be represented by substituents including for example oxygen or sulfur; an alkyl group such as a methyl, ethyl, propyl or isopropyl group; a halogen such as chloro, bromo or iodo group, a hydroxyl group, an amino group, a (di)alkylamino group, or an alkoxy group.

Preferably, the linking group represents an optionally substituted divalent aliphatic group including a straight or branched carbon chain or an alicyclic, non-aromatic ring, an optionally substituted aromatic ring and/or -CO-O- or -CONH- group. The optional substituents may contain substituents including for example oxygen or sulfur; alkyl groups such as a methyl, ethyl, propyl or isopropyl group and halogens such as a fluoro, chloro, bromo or iodo atom.

The monomer including a mercaptotetrazole group is more preferably represented by the following Formula (IV): 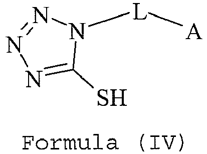 wherein
L represents a divalent linking group as defined above for Formula (III) and;
A is as defined above for Formula (III).

In a preferred embodiment, A in the Formulae (III) and (IV) represents acrylamide or methacrylamide.

Without being limited thereto, typical examples of the compounds used in the present invention are given below.

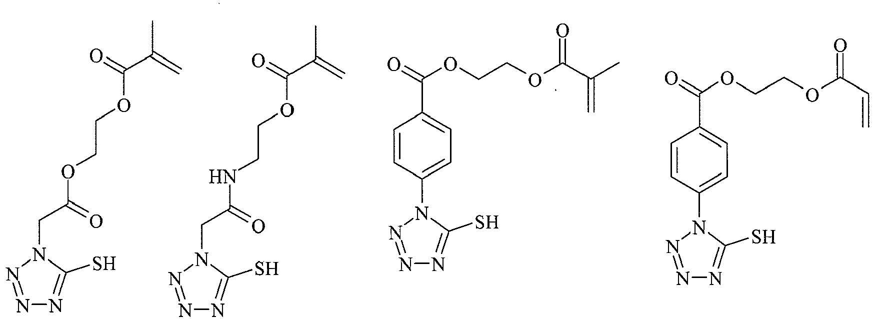

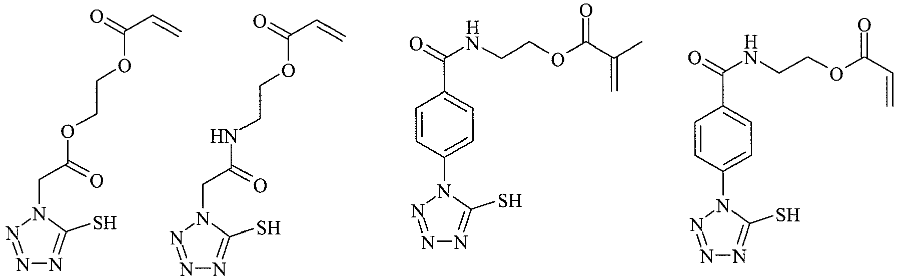

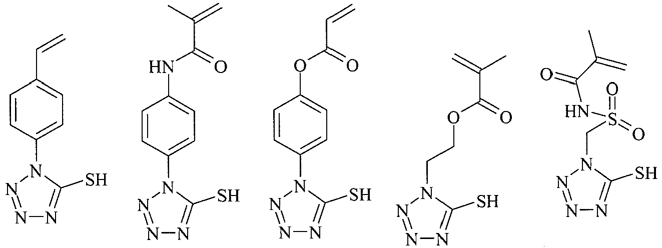

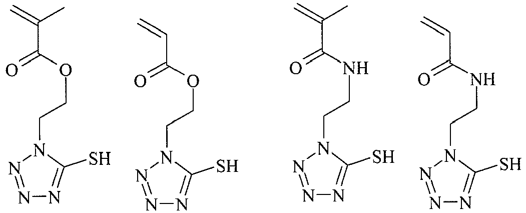

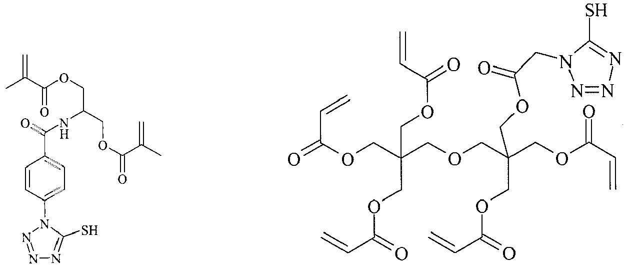

In a preferred embodiment, the printing plate precursor used in the present invention comprises a polymer including a monomeric unit derived from the monomer according to Formulae (I) or (II), and is further also referred to as "the mercaptotetrazole binder". A monomeric unit, also called repeating unit, is a building block of a polymer and contains the same kind and quantity of atoms as the monomer it is derived from.

The mercaptotetrazole binder may further include one or more other monomeric units, preferably selected from an acrylate or methacrylate e.g. an alkyl or aryl (meth)acrylate such as methyl (meth)acrylate, ethyl (meth)acrylate, butyl (meth)acrylate, benzyl (meth)acrylate, 2-phenylethyl (meth)acrylate, hydroxylethyl (meth)acrylate, phenyl (meth)acrylate or N-(4-metylpyridyl)(meth)acrylate; (meth)acrylic acid; a (meth)acrylamide e.g. (meth)acrylamide or a N-alkyl or N-aryl (meth)acrylamide such as N-methyl (meth)acrylamide, N-ethyl (meth)acrylamide, N-phenyl (meth)acrylamide, N-benzyl (meth)acrylamide, N-methylol (meth)acrylamide, N-(4-hydroxyphenyl)(meth)acrylamide; (meth)acrylonitrile; styrene; a substituted styrene such as 2-, 3-or 4-hydroxy-styrene, 4-benzoic acid-styrene; a vinylpyridine such as 2-vinylpyridine, 3-vinylpyridine, 4-vinylpyridine; a substituted vinylpyridine such as 4-methyl-2-vinylpyridine; vinyl acetate, optionally the copolymerised vinyl acetate monomeric units are at least partially hydrolysed, forming an alcohol group, and/or at least partially reacted by an aldehyde compound such as formaldehyde or butyraldehyde, forming an acetal or butyral group; vinyl alcohol; vinyl acetal; vinyl butyral; a vinyl ether such as methyl vinyl ether; vinyl amide; a N-alkyl vinyl amide such as N-methyl vinyl amide, caprolactame, vinyl pyrrolydone; maleic anhydride, a maleimide e.g. maleimide or a N-alkyl or N-aryl maleimide such as N-benzyl maleimide.

In a preferred embodiment, the mercaptotetrazole binder further includes monomeric units selected from vinyl acetate, vinyl alcohol and vinyl acetale. The vinyl acetale is preferably represented by Formula (V): 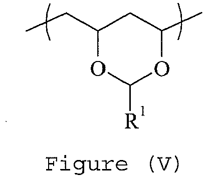 wherein R¹ represents an aliphatic carbon chain such as a methyl, ethyl, propyl, butyl or pentyl group, an optionally substituted aryl group such as a phenyl, benzyl, naphthyl, tolyl, ortho- meta- or para-xylyl, anthracenyl or phenanthrenyl, or an optionally substituted heteroaryl group such as a pyridyl, pyrimidyl, pyrazoyl, triazinyl, imidazolyl, furyl, thienyl, isoxazolyl, thiazolyl and carbazoyl group. Most preferably the vinyl acetale is selected from vinyl formal, vinyl ethyral, vinyl propyral and/or vinyl butyral.

The mercaptotetrazole binder is preferably represented by Formula(VI): 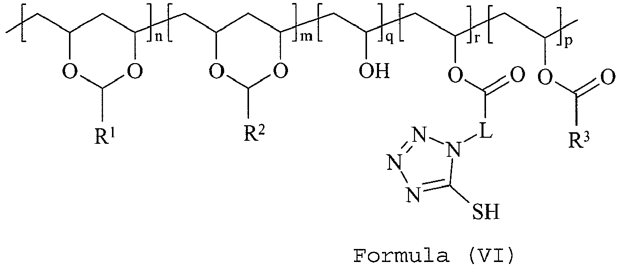
wherein R¹ is as defined above and R² and R³ independently represent an alkyl group; preferably R¹ represents methyl, ethyl, propyl, butyl or pentyl group;
n is in the range of 10 to 55 mol%,
m is in the range of 10 to 55 mol%,
q is in the range of 10 to 60 mol%,
r is in the range of 0.5 to 60 mol%, and
p is in the range of 0 to 10 mol%.

The molar percentage r of the monomeric units according to Formula (VI) is more preferably between 5 and 40 mol % and most preferably between 10 and 20 mol %. The mercaptotetrazole binder used in the present invention has preferably a molecular weight ranging for Mₙ, i.e. number average molecular weight, between 10000 and 500000, more preferably between 15000 and 250000, most preferably between 20000 and 200000, and for M_{w}, i.e. weight average molecular weight, between 10000 and 1000000, more preferably between 50000 and 800000, most preferably between 60000 and 600000. The numeric average molecular weight (Mn) and the weight average molecular weight (Mw) are each determined by size exclusion chromatography.

Besides the monomer including a mercaptotetrazole group and/or the mercaptotetrazole binder, the photopolymerizable layer may include a further binder. The binder can be selected from a wide series of organic polymers. Compositions of different binders can also be used. Useful binders are described in WO2005/111727 page 17 line 21 to page 19 line 30, EP 1 043 627 in paragraph [0013] and in WO2005/029187 page 16 line 26 to page 18 line 11.

The organic polymers used as binders have a typical average molecular weight M_{w} between 1000 and 700 000, preferably between 1500 and 350 000. Preferably, the binders have a hydroxyl number between 0 and 750, more preferably between 10 and 500. Even more preferably the hydroxyl number is below 10, most preferably the hydroxyl number is 0. The amount of binder(s) generally ranges from 1 to 60 % by weight, preferably 5 to 50 % by weight, more preferably 10 to 35 % by weight and most preferably 15 to 25 % by weight relative to the total weight of the non-volatile components of the composition.

In another embodiment the polymeric binder comprises a backbone including poly(alkylene oxide), urethane moieties and/or urea bonds; and pendant groups including hydrophilic poly(alkylene oxide) segments and/or ethylenically unsaturated polymerisable groups. The polymeric binder may also include pendant cyano groups attached to the backbone. A combination of such binders may also be employed. Generally the polymeric binder is solid at room temperature, and is typically a non-elastomeric thermoplastic. Generally the polymeric binder is characterized by a number average molecular weight (Mn) in the range from about 500 to 250000, more commonly in the range from about 1000 to 240000 or 1500 to 200000. The polymerisable composition may comprise discrete particles of the polymeric binder. Preferably the discrete particles are particles of the polymeric binder which are suspended in the polymerisable composition. The presence of discrete particles tends to promote developability of the unexposed areas. Specific examples of the polymeric binders according to this embodiment are described in US 6,899,994; US 2004/0260050, US 2005/0003285, US 2005/0170286 and US 2005/0123853. Other suitable binders as described in EP 2 471 655, EP 2 492 748 and EP 2 660 068 include multifunctional thiols having 6 to 10 functional groups as a nucleus (central skeleton) and polymer chains connected to the nucleus through sulfide bonds. In addition to the polymeric binder of this embodiment the imageable layer may optionally comprise one or more co-binders. Typical co-binders are water-soluble or water-dispersible polymers, such as, cellulose derivatives, polyvinylalcohol, polyacrylic acid poly(meth)acrylic acid, polyvinylpyrrolidone, polylactide, polyvinylphosphonic acid, synthetic co-polymers, such as co-polymers of an alkoxy polyethylene glycol (meth)acrylate. Specific examples of co-binders are described in US 2004/0260050, US 2005/0003285 and US 2005/0123853. Printing plate precursors, the imageable layer of which comprises a binder and optionally a co-binder according this embodiment and described in more detail in US 2004/0260050, US 2005/0003285 and US 2005/0123853, optionally comprising a topcoat and an interlayer.

In the present invention, suitable alkyl groups include 1 or more carbon atoms such as for example C₁ to C₂₂-alkyl groups, more preferably C₁ to C₁₂-alkyl groups and most preferably C₁ to C₆-alkyl groups. The alkyl group may be lineair or branched such as for example methyl, ethyl, propyl (n-propyl, isopropyl), butyl (n-butyl, isobutyl, t-butyl), pentyl, 1,1-dimethyl-propyl, 2,2-dimethylpropyl and 2-methyl-butyl, or hexyl. The alkyl group may be cyclic; suitable cycloalkyl groups are non-aromatic, homocyclic groups containing carbon atoms and may be monocyclic- or polycyclic. Examples include cyclopentyl, cyclohexyl or adamantyl. An alkylene group or a cycloalkylene group is derived from an alkyl group or a cycloalkyl group where a hydrogen atom is removed from two carbon atoms.

In the present invention, an arylene group is derived from an aryl group where a hydrogen atom is removed from two ring carbon atoms. Suitable aryl groups include for example phenyl, naphthyl, benzyl, tolyl, ortho- meta- or para-xylyl, anthracenyl or phenanthrenyl.

In the present invention, a heteroarylene group is derived from a heteroaryl group where a hydrogen atom is removed from two ring carbon atoms. Suitable heteroaryl groups are preferably monocyclic- or polycyclic aromatic rings comprising carbon atoms and one or more heteroatoms in the ring structure. Preferably 1 to 4 heteroatoms are independently selected from nitrogen, oxygen, selenium and sulphur and/or combinations thereof. Examples include pyridyl, pyrimidyl, pyrazoyl, triazinyl, imidazolyl, (1,2,3,)- and (1,2,4)-triazolyl, tetrazolyl, furyl, thienyl, isoxazolyl, thiazolyl and carbazoyl.

The substituents optionally present on the groups described above are preferably selected from an alkyl, ester, amide, ether, thioether, ketone, aldehyde, hydroxyl, thiol, cyanide, nitro, amino, (di)alkylamino, alkoxy, sulfoxide, sulfone, sulfonate ester or sulphonamide group, a halogen such as fluoro, chloro, bromo or iodo atom, and/or combinations thereof. More preferably, the optional substituents are represented by a halogen such as a fluoro, chloro, bromo or iodo atom, a hydroxyl group, an amino group, a (di)alkylamino group or an alkoxy group.

The lithographic printing plate precursor according to the present invention is negative-working, i.e. after exposure and development the non-exposed areas of the coating are removed from the support and define hydrophilic (non-printing) areas, whereas the exposed coating is not removed from the support and defines oleophilic (printing) areas. The hydrophilic areas are defined by the support which has a hydrophilic surface or is provided with a hydrophilic layer. The hydrophobic areas are defined by the coating, hardened upon exposing, optionally followed by a heating step. Areas having hydrophilic properties means areas having a higher affinity for an aqueous solution than for an oleophilic ink; areas having hydrophobic properties means areas having a higher affinity for an oleophilic ink than for an aqueous solution.

"Hardened" means that the coating becomes insoluble or non-dispersible for the developing solution and may be achieved through polymerization and/or crosslinking of the photosensitive coating, optionally followed by a heating step to enhance or to speed-up the polymerization and/or crosslinking reaction. In this optional heating step, hereinafter also referred to as "pre-heat", the plate precursor is heated, preferably at a temperature of about 80°C to 150°C and preferably during a dwell time of about 5 seconds to 1 minute.

The coating has at least one layer including a photopolymerisable composition, said layer is also referred to as the "photopolymerisable layer". The coating may include an intermediate layer, located between the support and the photopolymerisable layer.

The amount of the monomer including a mercaptotetrazole group and/or the mercaptotetrazole binder in the photopolymerisable layer is preferably above 1 %wt, more preferably above 2 %wt and most preferably above 5% wt relative to the total weight of all ingredients in the photopolymerisable layer. Alternatively, the monomer including a mercaptotetrazole group and/or the mercaptotetrazole binder is preferably present in the coating at a concentration between 5 and 50%wt, more preferably between 8 and 30%wt, and most preferably between 10 and 15%wt relative to the total weight of all ingredients in the coating.

The photopolymerisable layer includes, besides the monomer including a mercaptotetrazole group and/or the mercaptotetrazole binder, a polymerisable compound, optionally a binder, a polymerization initiator capable of hardening said further polymerisable compound in the exposed areas, and optionally a sensitizer capable of absorbing light used in the image-wise exposing step. The photopolymerisable layer has a coating thickness preferably ranging between 0.2 and 5.0 g/m², more preferably between 0.4 and 3.0 g/m², most preferably between 0.6 and 2.2 g/m².

According to a preferred embodiment of the present invention, the polymerisable compound is a polymerisable monomer or oligomer including at least one terminal ethylenic group, hereinafter also referred to as "free-radical polymerisable monomer", and the polymerisation initiator is a compound capable of generating free radicals upon exposure, optionally in the presence of a sensitizer, hereinafter said initiator is referred to as "free radical initiator". The polymerisation involves the linking together of the free-radical polymerisable monomers.

Suitable free-radical polymerisable monomers include, for example, multifunctional (meth)acrylate monomers (such as (meth)acrylate esters of ethylene glycol, trimethylolpropane, pentaerythritol, ethoxylated ethylene glycol and ethoxylated trimethylolpropane, multifunctional urethanated (meth)acrylate, and epoxylated (meth)acrylate), and oligomeric amine diacrylates. The (meth)acrylic monomers may also have other double bond or epoxide group, in addition to (meth)acrylate group. The (meth)acrylate monomers may also contain an acidic (such as carboxylic acid) or basic (such as amine) functionality.

Any free radical initiator capable of generating free radicals upon exposure directly or in the presence of a sensitizer, is according to this invention a suitable initiator. Suitable free-radical initiators are described in WO 2005/111727 from page 15 line 17 to page 16 line 11.

In a preferred embodiment of the present invention the photopolymerisable composition comprises a hexaaryl-bisimidazole compound (HABI; dimer of triaryl-imidazole) as polymerisation initiator, optionally in combination with further polymerisation initiators.

A procedure for the preparation of hexaarylbisimidazoles is described in DE 1470 154 and their use in photopolymerisable compositions is documented in EP 24 629, EP 107 792, US 4,410,621; EP 215 453 and DE 3 211 312. Preferred derivatives are e.g. 2,4,5,2',4',5'-hexaphenylbisimidazole, 2,2'-bis(2-chlorophenyl)-4,5,4',5'-tetraphenylbisimidazole, 2,2'-bis(2-chlorophenyl)-4,5,4',5'-tetrakis(3-methoxyphenyl)bisimidazole and 2,2'-bis(2-nitrophenyl)-4,5,4',5'-tetraphenylbisimidazole. The amount of the HABI polymerization initiator typically ranges from 0.01 to 30 % by weight, preferably from 0.5 to 20 % by weight, relative to the total weight of the non volatile components of the photopolymerisable composition.

A very high sensitivity can be obtained in the context of the present invention by the combination of an optical brightener as sensitizer and a hexaarylbisimidazole compound as polymerisation initiator.

Suitable classes of polymerisation initiators other than hexaarylbisimidazole compounds include aromatic ketones, aromatic onium salts, organic peroxides, thio compounds, ketooxime ester compounds, borate compounds, azinium compounds, metallocene compounds, active ester compounds and compounds having a carbon-halogen bond, but preferably the composition comprises a non-boron comprising polymerisation initiator and particularly preferred the polymerisation initiator comprises no boron compound. Many specific examples of initiators suitable for the present invention can be found in EP-A 1 091 247. Other preferred polymerization initiators are trihalo methyl sulphones.

Preferably hexaarylbisimidazole compounds and/or metallocene compounds are used alone or in combination with other suitable photoinitiators, in particular with aromatic ketones, aromatic onium salts, organic peroxides, thio compounds, ketoxime ester compounds, azinium compounds, active ester compounds or compounds having a carbon halogen bond.

In a preferred embodiment of the present invention the hexaarylbisimidazole compounds make more than 50 mol%, preferably at least 80 mol% and particularly preferred at least 90 mol% of all the photoinitiators used in the photopolymerisable composition of the present invention.

The photopolymerisable layer may also comprise a multifunctional monomer. This monomer contains at least two functional groups selected from an ethylenically unsaturated group and/or an epoxy or vinyl ether group. Particular multifunctional monomers for use in the photopolymer coating are disclosed in US 6,410,205 , US 5,049,479 , EP 1 079 276 , EP 1 369 232 , EP 1 369 231, EP 1 341 040 , US 2003/0124460 , EP 1 241 002 , EP 1 288 720 and in the reference book including the cited references: Chemistry & Technology UV & EB formulation for coatings, inks & paints - Volume 2 -Prepolymers and Reactive Diluents for UV and EB Curable Formulations by N.S. Allen, M.A. Johnson, P.K.T. Oldring, M.S. Salim - Edited by P.K.T. Oldring - 1991 - ISBN 0 947798102. Particularly preferred are urethane (meth)acrylate multifunctional monomers, which can be used alone or in combination with other (meth)acrylate multifunctional monomers.

The photopolymerisable layer may also comprise a co-initiator. Typically, a co-initiator is used in combination with a free radical initiator. Suitable co-initiators for use in the photopolymer coating are disclosed in US 6,410,205; US 5,049,479; EP 1 079 276, EP 1 369 232, EP 1 369 231, EP 1 341 040, US 2003/0124460, EP 1 241 002, EP 1 288 720 and in the reference book including the cited refences: Chemistry & Technology UV & EB formulation for coatings, inks & paints - Volume 3 -Photoinitiators for Free Radical and Cationic Polymerisation by K.K. Dietliker - Edited by P.K.T. Oldring - 1991 - ISBN 0 947798161. Specific co-initiators, as described in EP 107 792, may be present in the photopolymerizable layer to further increase the sensitivity. Preferred co-initiators are sulfur-compounds, especially thiols like e.g. 2-mercaptobenzothiazole, 2-mercaptobenzoxazole, 2-mercapto-benzimidazole, 4-methyl-3-propyl-1,2,4-triazoline-5-thione, 4-methyl-3-n-heptyl-1,2,4-triazoline-5-thione, 4-phenyl-3-n-heptyl-1,2,4-triazoline-5-thione, 4-phenyl-3,5-dimercapto-1,2,4-triazole, 4-n-decyl-3,5-dimercapto-1,2,4-triazole, 5-phenyl-2-mercapto-1,3,4-oxadiazole, 5-methylthio-1,3,4-thiadiazoline-2-thione, 5-hexylthio-1,3,4-thiadiazoline-2-thione, mercaptophenyltetrazole, pentaerythritol mercaptopropionate, butyric acid-3-mercapto-neopentanetetrayl ester, pentaerythritol tetra(thioglycolate). Other preferred co-initiators are polythioles as disclosed in WO 2006/048443 and WO 2006/048445. These polythiols may be used in combination with the above described thiols, e.g. 2-mercaptobenzothiazole.

The photopolymerisable layer may also comprise particles which increase the resistance of the coating against manual or mechanical damage. The particles may be inorganic particles, such as for example silica, alumina, iron oxides, magnesium carbonate, titanium oxide and calcium carbonate. The particles may be organic particles or fillers, such as for example polymer particles, waxes, carbon black and silicone resins. The particles preferably have a particle size of about 0.01 to 2 µm. More information on suitable particles is described in for example US 7,108,956.

The photopolymerisable layer may also comprise organic or inorganic spacer particles which increase the resistance of the coating against manual or mechanical damage. The spacer particles have preferably a particle size larger than 0.5 *µ*m, more preferably a particle size larger than 0.8 *µ*m, most preferably equal to or larger than 1.0 *µ*m. The particle size is preferably comprised between 0.5 *µ*m and 15 *µ*m, more preferably between 0.5 *µ*m and 7 *µ*m, most preferably between 1 *µ*m and 5 *µ*m. The particle size refers to the average particle size and may be measured by a laser diffraction particle analyzer such as the Coulter LS Particle Size Analyzer, e.g. the Coulter LS-230, commercially available by Beckman Coulter Inc. The average particle size is defined as the mean or median of the volume distribution of particle size.

For obtaining a significant effect of improving the resistance of the coating against manual or mechanical damage, the spacer particles should extend the surface of the coating. The coating has preferably a layer thickness greater than 0.5 g/m², more preferably the layer thickness is comprised between 0.6 g/m² and 2.8 g/m². The particle size of the spacer particles is preferably comprised between one to two times the thickness of the coating.

Examples of inorganic spacer particles include silicium, titanium, aluminium, zinc, iron, chromium or zirconium containing particles, metal oxides or hydroxides thereof, aluminiumsilicates, and metal salts such as calcium carbonate, barium sulfate, barium titanate and strontium titanate.

Examples of organic spacer particles include optionally cross-linked polyalkyl(meth)acrylate such as polymethylmethacrylate, polystyrene, melamine, polyolefins such as polyethylene or polypropylene, halogenated polyolefins such as fluorinated polyolefins for example polytetrafluoroethylene, silicones such as cross-linked polysiloxane particles, or copolymers thereof. Examples of polysiloxane particles include cross-linked polyalkylsiloxanes such as polymethylsiloxane. Commercially available cross-linked polysiloxane particles are for example Tospearl from Toshiba Silicone Co.,Ltd.

The photopolymerizable layer may also comprise an inhibitor. Particular inhibitors for use in the photopolymer coating are disclosed in US 6,410,205, EP 1 288 720 and EP 1 749 240.

The photopolymerizable layer may further comprise an adhesion promoting compound. The adhesion promoting compound is a compound capable of interacting with the support, preferably a compound having an addition-polymerizable ethylenically unsaturated bond and a functional group capable of interacting with the support. Under "interacting" is understood each type of physical andlor chemical reaction or process whereby, between the functional group and the support, a bond is formed which can be a covalent bond, an ionic bond, a complex bond, a coordinate bond or a hydrogen-bridge bond, and which can be formed by an adsorption process, a chemical reaction, an acid-base reaction, a complex-forming reaction or a reaction of a chelating group or a ligand. The adhesion promoting compound may be selected from at least one of the low molecular weight compounds or polymeric compounds as described in EP-A 851 299 from lines 22 on page 3 to line 1 on page 4, EP-A 1 500498 from paragraph [0023] on page 7 to paragraph [0052] on page 20, EP-A 1 495866 paragraph [0030] on page 5 to paragraph[0049] on page 11, EP-A 1 091 251 from paragraph [0014] on page 3 to paragraph [0018] on page 20, and EP-A 1 520 694 from paragraph [0023] on page 6 to paragraph [0060] on page 19. Preferred compounds are those compounds which comprise a phosphate or phosphonate group as functional group capable of adsorbing on the aluminium support and which comprise an addition-polymerizable ethylenic double bond reactive group, especially those described in EP- 25 A 851 299 from lines 22 on page 3 to line 1 on page 4 and EP-A 1 500498 from paragraph [0023] on page 7 to paragraph [0052] on page 20. Also preferred are those compounds which comprises a tri-alkyloxy silane groups wherein the alkyl is preferably methyl or ethyl, or wherein the trialkyloxy silane groups are at least partially hydrolysed to silanol groups, as functional group capable of adsorbing on the support, especially silane coupling agents having an addition-polymerizable ethylenic double bond reactive group as described in EP-A 1 557262 paragraph [0279] on page 49 and EP-A 1 495 866 paragraph [0030] on page 5 to paragraph [0049] on page 11. The adhesion promoting compound may be present in the photopolymerizable layer in an amount ranging between 1 and 50 wt%, preferably between 3 and 30 wt%, more preferably between 5 and 20 wt% of the non-volatile components of the composition. More details on adhesion promoting compounds can be found in WO2013/182328.

Various surfactants may be added into the photopolymerisable layer to allow or enhance the developability of the precursor; especially developing with a gum solution. Both polymeric and small molecule surfactants can be used. Nonionic surfactants are preferred. Preferred nonionic surfactants are polymers and oligomers containing one or more polyether (such as polyethylene glycol, polypropylene glycol, and copolymer of ethylene glycol and propylene glycol) segments. Examples of preferred nonionic surfactants are block copolymers of propylene glycol and ethylene glycol (also called block copolymer of propylene oxide and ethylene oxide); ethoxylated or propoxylated acrylate oligomers; and polyethoxylated alkylphenols and polyethoxylated fatty alcohols. The nonionic surfactant is preferably added in an amount ranging between 0.01 and 20% by weight of the coating, more preferably between 0.1 and 10% by weight of the coating, and most preferably between 0.5 and 5% by weight of the coating.

Suitable examples of optical brighteners as sensitizers are described in WO 2005/109103 page 24, line 20 to page 39. The photocurable composition may also comprise other sensitizers. Highly preferred sensitizers are violet light absorbing sensitizers, having an absorption spectrum between 350 nm and 450 nm, preferably between 370 nm and 420 nm, more preferably between 390 nm and 415 nm. Particular preferred sensitizers are disclosed in EP 1 349 006 paragraph [0007] to [0009], EP 1 668 417 and WO 2004/047930, including the cited references in these patent applications. Other highly preferred sensitizers are infrared light absorbing dyes, having an absorption spectrum between 750 nm and 1300 nm, preferably between 780 nm and 1200 nm, more preferably between 800 nm and 1100 nm. Particular preferred sensitizers are heptamethinecyane dyes, especially the dyes disclosed in EP 1 359 008 paragraph [0030] to [0032]. Other preferred sensitizers are blue, green or red light absorbing sensitizers, having an absorption spectrum between 450 nm and 750 nm. Useful sensitizers can be selected from the sensitizing dyes disclosed in US 6,410,205; US 5,049,479; EP 1 079 276, EP 1 369 232, EP 1 369 231, EP 1 341 040, US 2003/0124460, EP 1 241 002 and EP 1 288 720.

The photopolymerisable layer or an optional other layer of the coating may also comprise a colorant. After processing, at least part of the colorant remains on the hardened coating areas, and a visible image can be produced on the support by removing the coating, including the colorant, at the non-exposed areas. The colorant can be a dye or a pigment. Various types of pigments can be used such as organic pigments, inorganic pigments, carbon black, metallic powder pigments and fluorescent pigments. Organic pigments are preferred.

Specific examples of organic pigments include quinacridone pigments, quinacridonequinone pigments, dioxazine pigments, phthalocyanine pigments, anthrapyrimidine pigments, anthanthrone pigments, indanthrone pigments, flavanthrone pigments, perylene pigments, diketopyrrolopyrrole pigments, perinone pigments, quinophthalone pigments, anthraquinone pigments, thioindigo pigments, benzimidazolone pigments, isoindolinone pigments, azomethine pigments, and azo pigments.

Specific examples and more detailed information of pigments suitable as colorant in the current invention are described in EP 2 278 404 in paragraphs [0064] to [0068].

Typically, the amount of pigment in the coating may be in the range of about 0.005 g/m² to 2 g/m², preferably about 0.007 g/m to 0.5 g/m², more preferably about 0.01 g/m² to 0.2 g/m², most preferably about 0.01 g/m² to 0.1 g/m².

The colorant can also be a dye. Any known dyes, such as commercially available dyes or dyes described in, for example, "Dye Handbook" (edited by the Organic Synthetic Chemistry Association, published in 1970) which are colored for the human eye, can be used as colorant in the photopolymerisable coating. Specific examples thereof are described in EP 2 278 404 in paragraph [0070].

Typically, the amount of dye in the coating may be in the range of about 0.005 g/m² to 2 g/m², preferably about 0.007 g/m² to 0.5 g/m², more preferably about 0.01 g/m² to 0.2 g/m², most preferably about 0.01 g/m² to 0.1 g/m².

The photopolymerisable layer or an optional other layer of the coating may include a printing-out agent, i.e. a compound which is capable of changing the color of the coating upon exposure. After image-wise exposing of the precursor, a visible image can be produced, hereinafter also referred to as "print-out image". The printing-out agent may be a compound as described in EP-A-1 491 356 paragraph [0116] to [0119] on page 19 and 20, and in US 2005/8971 paragraph [0168] to [0172] on page 17. Preferred printing-out agents are the compounds described in EP 1 765 592 from line 1 page 9 to line 27 page 20. More preferred are the IR-dyes as described in EP 1 736 312 from line 32 page 5 to line 9 page 32. The contrast of the image formed after image-wise exposure and processing is defined as the difference between the optical density at the exposed area to the optical density at the non-exposed area, and this contrast is preferably as high as possible. This enables the end-user to establish immediately whether or not the precursor has already been exposed and processed, to distinguish the different color selections and to inspect the quality of the image on the plate precursor. The contrast increases with increasing optical density in the exposed areas and/or decreasing optical density in the non-exposed areas. The optical density in the exposed area may increase with the amount and extinction coefficient of the colorant remaining in the exposed areas and the intensity of color formed by the printing-out agent. In the non-exposed areas it is preferred that the amount of colorant is as low as possible and that the intensity of color print-out agent is as low as possible. The optical density can be measured in reflectance using an optical densitometer, equipped with several filters (e.g. cyan, magenta, yellow). The difference in optical density in the exposed area and the non-exposed area has preferably a value of at least 0.3, more preferably at least 0.4, most preferably at least 0.5. There is no specific upper limit for the contrast value, but typically the contrast is not higher than 3.0 or even not higher than 2.0. In order to obtain a good visual contrast for a human observer the type of color of the colorant may also be important. Preferred colors for the colorant are cyan or blue colors, i.e. under blue color we understand a color that appears blue for the human eye.

The coating may include on the photopolymerisable layer, a toplayer or protective overcoat layer which acts as an oxygen barrier layer including water-soluble or water-swellable binders. Printing plate precursors which do not contain a toplayer or protective overcoat layer are also referred to as overcoat-free printing plate precursors. In the art, it is well-known that low molecular weight substances present in the air may deteriorate or even inhibit image formation and therefore usually a toplayer is applied to the coating. A toplayer should be easily removable during development, adhere sufficiently to the photopolymerisable layer or optional other layers of the coating and should preferably not inhibit the transmission of light during exposure. Preferred binders which can be used in the toplayer are polyvinyl alcohol and the polymers disclosed in WO 2005/029190; US 6,410,205 and EP 1 288 720, including the cited references in these patents and patent applications. The most preferred binder for the toplayer is polyvinylalcohol. The polyvinylalcohol has preferably a hydrolysis degree ranging between 74 mol % and 99 mol %, more preferably between 88-98%. The weight average molecular weight of the polyvinylalcohol can be measured by the viscosity of an aqueous solution, 4 % by weight, at 20°C as defined in DIN 53 015, and this viscosity number ranges preferably between 3 and 26, more preferably between 3 and 15, most preferably between 3 and 10.

The overcoat layer may optionally include other ingredients such as inorganic acids e.g. HCL, HBr, HI, HF, sulphuric acid, nitric acid or phosphoric acid; organic acids such as aliphatic or aromatic hydrocarbons having one or more acid groups; matting agents; polymers including 3 to 10 chains branched from a central skeleton; spacer particles as described above; wetting agents such as for example alkylene glycol, dialkylene glycol, glycerin, trimethylol propane and diglycerin; anionic surfactants e.g. sodium alkyl sulphate or sodium alkyl sulphonate; amphoteric surfactants e.g. alkylaminocarboxylate and alkylamino-dicarboxylate; non-ionic surfactants e.g. perfluoro-surfactants, polyoxyethylene alkyl phenyl ether; alkoxylated alkylene diamines; alkoxylated alkanols, phosphoric acid alkyl esters, phosphonic acid alkyl esters; glycerine; cellulose; inorganic particles such as silicon or titanium dioxide particles, natural or synthetic micas and pigments; antiseptic and an anti-foaming agents such as silicone anti-foaming agents and ink receptivity agents.

The coating thickness of the optional toplayer is preferably between 0.25 and 1.75 g/m², more preferably between 0.25 and 1.3 g/m², most preferably between 0.25 and 1.0 g/m². In a more preferred embodiment of the present invention, the optional toplayer has a coating thickness between 0.25 and 1.75 g/m² and comprises a polyvinylalcohol having a hydrolysis degree ranging between 74 mol % and 99 mol % and a viscosity number as defined above ranging between 3 and 26.

The support is preferably a grained and anodized aluminium support, well known in the art. Suitable supports are for example disclosed in EP 1 843 203 (paragraphs [0066] to [0075]). The surface roughness, obtained after the graining step, is often expressed as arithmetical mean center-line roughness Ra (ISO 4287/1 or DIN 4762) and may vary between 0.05 and 1.5 µm. The aluminum substrate of the current invention has preferably an Ra value below 0.45 µm, more preferably below 0.40 µm and most preferably below 0.30 µm. The lower limit of the Ra value is preferably about 0.1 µm. More details concerning the preferred Ra values of the surface of the grained and anodized aluminum support are described in EP 1 356 926. By anodising the aluminum support, an Al₂O₃ layer is formed and the anodic weight (g/m² Al₂O₃ formed on the aluminum surface) varies between 1 and 8 g/m². The anodic weight is preferably ≥ 3 g/m², more preferably ≥ 3.5 g/m² and most preferably ≥ 4.0 g/m²

The grained and anodized aluminium support may be subjected to so-called post-anodic treatments, for example a treatment with polyvinylphosphonic acid or derivatives thereof, a treatment with polyacrylic acid, a treatment with potassium fluorozirconate or a phosphate, a treatment with an alkali metal silicate, or combinations thereof. Alternatively, the support may be treated with an adhesion promoting compound such as those described in EP 1 788 434 in [0010] and in WO 2013/182328. However, for a precursor optimized to be used without a pre-heat step it is preferred to use a grained and anodized aluminium support without any post-anodic treatment.

Besides an aluminium support, a plastic support, for example a polyester support, provided with one or more hydrophilic layers as disclosed in for example EP 1 025 992 may also be used.

According to the present invention there is provided a method for making a negative-working lithographic printing plate comprising the steps of imagewise exposing a printing plate precursor followed by developing the imagewise exposed precursor so that the non exposed areas are dissolved in the developer solution. Optionally, after the imaging step, a heating step is carried out to enhance or to speed-up the polymerization and/or crosslinking reaction. According to a preferred embodiment of the present invention, the method does not include a heating step after imaging. In this embodiment, it is preferred that the support is grained and anodized and not post-treated. The lithographic printing plate precursor can be prepared by (i) applying on a support as described above the coating as described above and (ii) drying the precursor.

The image-wise exposing step can be carried out by a laser. Preferably, the image-wise exposing step is carried out off-press in a platesetter, i.e. an exposure apparatus suitable for image-wise exposing the precursor with a laser such as a laser diode, emitting around 830 nm, a Nd YAG laser, emitting around 1060 nm, a violet laser, emitting around 400 nm, or a gas laser such as an Ar laser, or with a digitally modulated UV-exposure set-up, using e.g. digital mirror devices, or by a conventional exposure in contact with a mask. In a preferred embodiment of the present invention, the precursor is image-wise exposed by a laser emitting IR-light or violet light.

During the optional heating step the plate precursor is heated, preferably at a temperature of about 80°C to 150°C and preferably during a dwell time of about 5 seconds to 1 minute. The preheating step is preferably carried out in a preheating unit which is preferably provided with heating elements such as IR-lamps, UV-lamps, heated air, a heated metal roll, etc.

After the exposure step or, when a preheating step is present, after the preheating step, the precursor may be washed in a prewashing station, whereby at least part of the toplayer, if present, can be removed by supplying a wash liquid, i.e. water or an aqueous solution, to the coating of the precursor. The washing liquid is preferably water, more preferably tap water. More details concerning the wash step are described in EP 1 788 434 in [0026].

After the exposure step, the optional heating step and the optional prewashing step, the precursor is developed with a developer solution or a processing liquid. During the development step, the non-exposed areas of the image-recording layer are at least partially removed without essentially removing the exposed areas. The processing liquid can be applied to the plate e.g. by rubbing with an impregnated pad, by dipping, immersing, coating, spincoating, spraying, pouring-on, either by hand or in an automatic processing apparatus. The treatment with a processing liquid may be combined with mechanical rubbing, e.g. by a rotating brush. During the development step, any water-soluble protective layer present is preferably also removed. The development is preferably carried out at temperatures between 20 and 40 °C in automated processing units.

The processing liquid is a gum solution whereby during the developent step the non-exposed areas of the photopolymerisable layer are removed from the support and the plate is gummed in a single step. Preferably, the gumming unit is mechanically coupled to the platesetter by conveying means wherein the precursor is shielded from ambient light. Development in a gumming station comprising at least one gumming unit is for example described in WO 2007/057348 on page 40 line 34 to page 44 line 14. A gum solution is typically an aqueous liquid which comprises one or more surface protective compounds that are capable of protecting the lithographic image of a printing plate against contamination, e.g. by oxidation, fingerprints, fats, oils or dust, or damaging, e.g. by scratches during handling of the plate. Suitable examples of such surface protective compounds are film-forming hydrophilic polymers or surfactants. The layer that remains on the plate after treatment with the gum solution preferably comprises between 0.005 and 20 g/m² of the surface protective compound, more preferably between 0.010 and 10 g/m², most preferably between 0.020 and 5 g/m². More details concerning the surface protective compounds in the gum solution can be found in WO 2007/057348 page 9 line 3 to page 11 line 6. As the developed plate precursor is developed and gummed in one step, there is no need to post-treat the processed plate.

The gum solution preferably has a pH value between 3 and 11, more preferably between 4 and 10, even more preferably between 5 and 9, and most preferably between 6 and 8. A suitable gum solution is described in for example EP 1 342 568 in [0008] to [0022]. The viscosity of the gum solution can be adjusted to a value of e.g. between 1.7 and 5 mPa.s, by adding viscosity increasing compounds, such as poly(ethylene oxide) or polyvinylalcohol, e.g. having a molecular weight between 10⁴ and 10⁷. Such compounds can be present in a concentration of 0.01 to 10 g/l.

The gum solution may further comprise an inorganic salt, an anionic surfactant, a wetting agent, a chelate compound, an antiseptic compound, an anti-foaming compound and/or an ink receptivity agent and/or combinations thereof. More details about these additional ingredients are described in WO 2007/057348 page 11 line 22 to page 14 line 19.

After the processing step the plate may be dried in a drying unit. In a preferred embodiment the plate is dried by heating the plate in the drying unit which may contain at least one heating element selected from an IR-lamp, an UV-lamp, a heated metal roller or heated air. In a preferred embodiment of the present invention, the plate is dried with heated air as known in the drying section of a classical developing machine.

After drying the plate, the plate can optionally be heated in a baking unit. More details concerning the heating in a baking unit can be found in WO 2007/057348 page 44 line 26 to page 45 line 20.

The printing plate thus obtained can be used for conventional, so-called wet offset printing, in which ink and an aqueous dampening liquid is supplied to the plate. Another suitable printing method uses a so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705.

### EXAMPLES

### I. Synthesis

### 1. Synthesis of the inventive polymers including a mercaptotetrazole group.

### Reaction scheme:

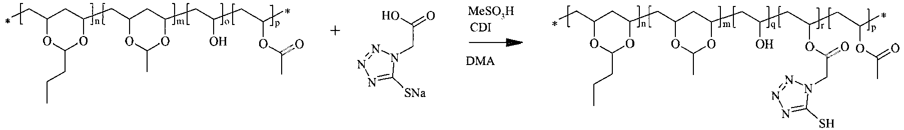

### General procedure:

In recipient A, 6.28 g (0.0345 mol) of monosodium salt of 5-mercapto-1-tetrazoleacetic acid was added to 40 g of dimethylacetamide. 3.18 g (0.0331 mol) methanesulfonic acid was added dropwise to the mixture and the mixture was stirred for 1 hour at room temperature. 8.08 g (0.0499 mol) 1,1'-carbonyldiimidazole was added and the reaction mixture was stirred for 1 hour at room temperature.

In recipient B, 11.41 g S-Lec BX35Z (a polyvinylacetal supplied by Sekisui bearing 14 mol% of free alcohol groups; 11.41 g S-Lec BX35Z = 0.0287 mol free alcohol groups) was added to 60 ml dimethylacetamide and the mixture was stirred for 2 hours at 80°C. The mixture was cooled down to room temperature and added to recipient A. The reaction was allowed to continue for 48 hours (Binder-01) or 21 hours (Binder-02) at room temperature and was terminated by the addition of 200 ml 1-methoxy-2-propanol. The mixture was added dropwise to 1.2 1 water and successively acidified to pH = 3.0 using a 1 molar hydrochloric acid solution. The precipitated polymer was filtered, washed with water and dried under vacuum until constant weight.

The substitution degree expressed as the conversion of free alcohol groups of the S-Lec BX35Z polymer into an ester function was determined by NMR in combination with FTIR for each polymer. The results are given in Table 1.

**Table 1**

| Inventive Binders | Substitution degree (%) |
|---|---|
| Binder-01 | 93 |
| Binder-02 | 60 |

### 2. Synthesis of the comparative polymers including a carboxylic acid group.

### Reaction scheme:

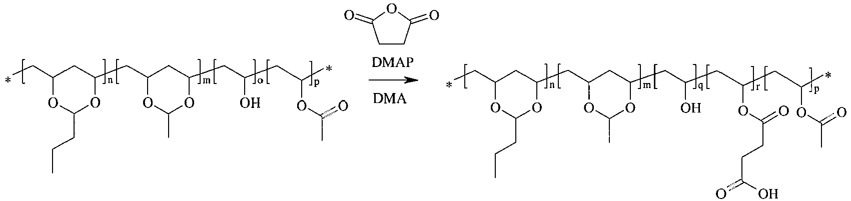

### General procedure:

5 g S-Lec BX35Z (a polyvinylacetal supplied by Sekisui bearing 14 mol% of free alcohol groups; 5 g S-Lec BX35Z = 0.0126 mol free alcohol groups) was added to 30 ml dimethylacetamide and the mixture was stirred for 2 hours at 80°C. The mixture was cooled down to room temperature and an equimolar amount (specified in the Table 2 below) of succinic anhydride and 4-dimethylaminopyridine (DMAP) was added. The reaction was allowed to continue over night at 60 °C. The reaction was terminated by the addition of 100 ml 1-methoxy-2-propanol. The mixture was added dropwise to 500 ml water and successively acidified to pH = 3.0 using a 1 molar hydrochloric acid solution. The precipitated polymer was filtered, washed with water and dried under vacuum until constant weight.

The substitution degree expressed as the conversion of free alcohol groups of the S-Lec BX35Z polymer into an ester function was determined by NMR in combination with FTIR for each polymer. The results are given in Table 2.

**Table 2**

| | S-Lec BX35Z | Succinic anhydride and DMAP (50%/50%) | Substitution degree |
|---|---|---|---|
| | (g) | (mol) | (%) |
| Binder-03 | 5 | 0.0189 | 100 |
| Binder-04 | 5 | 0.00504 | 34 |

### 3. Synthesis of the comparative polymers including a sulfonic acid group.

### Reaction scheme:

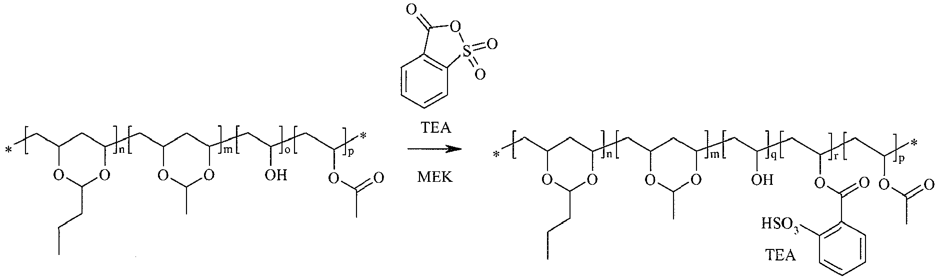

### General procedure:

20 g S-Lec BX35Z (a polyvinylacetal supplied by Sekisui bearing 14 mol% of free alcohol groups; 20 g S-Lec BX35Z = 0.0503 mol free alcohol groups) was added to 150 ml methylethylketon (MEK) and the mixture was stirred for 2 hours at 80°C. The mixture was cooled down to room temperature. An equimolar amount (specified in Table 3 below) of 2-sulfobenzoic anhydride and triethylamine (TEA) was added at room temperature. The reaction was allowed to continue over night under reflux. The reaction was terminated by the addition of 100 ml 1-methoxy-2-propanol. The mixture was added dropwise to 500 ml water. The polymer was precipitated by salting-out with triethylammonium chloride. The precipitated polymer was isolated by centrifugation and decantation, washed with water and dried under vacuum until constant weight.

The substitution degree expressed as the conversion of free alcohol groups of the S-Lec BX35Z polymer into an ester function was determined by NMR in combination with FTIR for each polymer. The results are given in Table 3.

**Table 3**

| | S-Lec BX35Z | 2-sulfobenzoic anhydride and TEA (50%/50%) | Substitution degree |
|---|---|---|---|
| | (g) | (mol) | (%) |
| Binder-05 | 20 | 0.0756 | 100 |
| Binder-06 | 20 | 0.0302 | 40 |

### II. Preparation of the aluminium support S-01

A 0.3 mm thick aluminium foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15 g/l HCl, 15 g/l SO₄²⁻ ions and 5 g/l Al³⁺ ions at a temperature of 37°C and a current density of about 100 A/dm². Afterwards, the aluminium foil was then desmutted by etching with an aqueous solution containing 5.5 g/l of NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm², then washed with demineralised water for 11 seconds and dried at 120°C for 5 seconds.

The support thus obtained was characterised by a surface roughness Ra of 0.35-0.4 *µ*m (measured with interferometer NT1100) and had an anodic weight of 3.0 g/m².

### Example 1

### 1. Preparation of the printing plates PP-01 to PP-07

### Coating

The printing plate precursors were produced by coating onto the above described support S-01 the components as defined in Table 4 dissolved in a mixture of 35% by volume of MEK and 65% by volume of Dowanol PM (1-methoxy-2-propanol, commercially available from DOW CHEMICAL Company). The coating solution PL-01 was applied at a wet coating thickness of 30 µm and then dried at 120°C for 1 minute in a circulation oven.

**Table 4: dry coating weight of the photopolymerisable layer PL-01**

| **INGREDIENT** (g/m²) | **PL**-**01 (Violet)** |
|---|---|
| Fluomix (1) | 0.075 |
| Binder (2) | 0.225 |
| FST 426R (3) | 0.900 |
| Tegoglide 410 (4) | 0.0023 |
| HABI (5) | 0.1125 |
| Pig-disp (6) | 0.180 |
| MBT (7) | 0.030 |
| Sipomer PAM100 (8) | 0.195 |
| Albritect CP30 (9) | 0.036 |
| **Dry coating weight** | 1.755 |

| | |
|---|---|
| (1) Fluomix is a violet sensitizer mixture consisting of the following compounds: 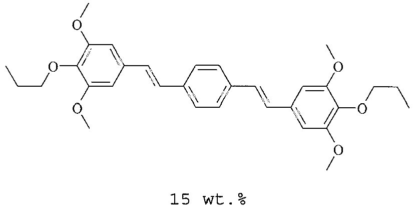 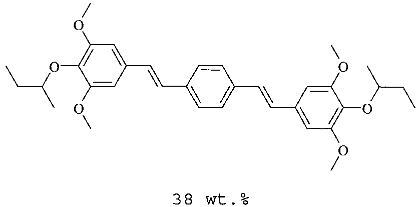 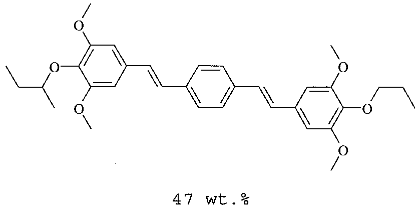 (2) see Table 6 below; (3) FST 426R™ is a reaction product from 1 mole of 2,2,4-trimethyl-hexamethylenediisocyanate and 2 moles of hydroxyethyl-methacrylate; (4) Tegoglide 410™ is a surfactant commercially available from EVONIK Tego CHEMIE GmbH; (5) HABI is 2,2'-bis(o-chlorophenyl)-4,4',5,5'-tetraphenylbiimidazole commercially available from SUMITOMO; (6) Pig-disp contains in a 50/50 ratio Hostaperm Blue P-BFSTM commercially available from CLARIANT and Disperbyk 182 commercially available from BYK CHEMIE GmbH; (7) MBT is 2-mercaptobenzthiazole; (8) Sipomer PAM100 is a phosphonated methacrylate commercially available from RHODIA; (9) Albritect CP30 as a vinyl copolymer of acrylic acid (70 mole%) and vinyl phosphonic acid (30 mole%) commercially available from RHODIA. | |

### Top layer OC-1

On top of the photosensitive layer PL-01 a solution in water with the composition as defined in Table 5 was coated (40 *µ*m) on the printing plate precursors and dried at 110°C for 2 minutes. The so-formed protective top layer OC-1 has a dry thickness or dry coating weight of 1.25 g/m². The printing plate precursors and PPP-01 to PPP-07 were obtained (see Table 6).

**Table 5: Composition of the top layer solution OC-01.**

| INGREDIENT (g) | OC-01 |
|---|---|
| Mowiol 4-88 (1) | 19.1 |
| Mowiol 8-88 (1) | 5.84 |
| Luviskol K30 (2) | 5.95 |
| Acticide LA1206 (3) | 0.06 |
| Lutensol A8 (4) | 0.30 |
| Water | 969 |

| | |
|---|---|
| (1) Mowiol 4-88™ and Mowiol 8-88™ are partially hydrolyzed polyvinylalcohols commercially available from KURARAY; (2) Luviskol K30™ is polyvinylpyrrolidone homopolymer commercially available from BASF; (3) Acticide LA1206™ is a biocide commercially available from THOR; (4) Lutensol A8™ is a surface active agent commercially available from BASF. | |

**Table 6: printing plate precursors PPP-01 to PPP-07.**

| **Printing plate precursors** | **BINDER*** |
|---|---|
| PPP-01 | Binder-ref |
| *Reference* | Unmodified |
| PPP-02 | Binder-01 |
| *inventive* | mercaptotetrazole |
| PPP-03 | Binder-02 |
| *inventive* | mercaptotetrazole |
| PPP-04 | Binder-03 |
| *comparative* | Carboxylic acid |
| PPP-05 | Binder-04 |
| *comparative* | Carboxylic acid |
| PPP-06 | Binder-05 |
| *comparative* | Sulfonic acid |
| PPP-07 | Binder-06 |
| *comparative* | Sulfonic acid |

| | |
|---|---|
| *: Binder ref: S-Lec BX35Za polyvinylacetal bearing 14 mol% of free alcohol group supplied by Sekisui; Binder-01 to Binder-06: synthesized as described above. | |

### Imaging

The printing plate precursors were subsequently imaged with a Galileo VXT platesetter at 2400 dpi (200 lpi Agfa Balanced Screening (ABS)) (commercially available from Agfa Graphics NV and equipped with a 405 nm violet laser diode) and this at energy density of approximately 50 *µ*J/cm².

### Processing

After imaging, the printing plate precursors were subjected to processing with VCF Gum NP (pH is 7 at room temperature, commercially available from Agfa Graphics NV) in a CRF45 processor™ (dwell time 30 s, at 21°C), available from Agfa Graphics NV, to remove the coating in the non-image areas from the support. This results in the printing plates PP-01 to PP-07 (see Table 6).

### 2. Results

### 1. Gum solubility

The gum solibility is defined as the capability of the gum solution to disperse the detached non-image areas homogeneously. The gum solubility is determined by rubbing a cotton pad soaked with Gum-1 (see above) in circular motion for 5 sec on a non-imaged plate precursor. The cotton pad is visually examined in terms of presence of speckles (yes/no) and/or the level of homogeneous coloration of the cotton pad. The level of homogeneous colouration is defined by a score from 0 to 5:
0 = a cotton pad completely homogeneously colored;
1 = a cotton pad that is for about 80% homogeneously colored;
2 = a cotton pad that is for about 60% homogeneously colored;
3 = a cotton pad that is for about 40% homogeneously colored;
4 = a cotton pad that is for about 20% homogeneously colored;
5 = a cotton pad that is completely unhomogeneously colored.

The results of the gum solubility evaluation is given in Table 7 below.

### 2. Press behaviour in terms of blinding

A specific test procedure was used to evaluate blinding behaviour; i.e. ink loss during printing.

First, the gum layer on the obtained plates PP-01 to PP-07 is washed away with water and the plates are dried. Then, the plates are wiped with concentrated standard non-diluted fountain solution FS404 AS (trademark of Agfa Graphics NV) using a cotton pad.

Secondly, the plates are mounted on the press (Heidelberg GTO 46 printing press available from Heidelberg), the plate cylinder is started and the inking rollers are dropped on the plates until they are completely covered with ink (K+E Novavit 800 Skinnex ink, trademark of BASF Druckfarben GmbH). A compressible blanket was used and printing was performed on non-coated offset paper using 2 wt% Prima FS404 (trademark of Agfa Graphics NV) in water as fountain solution.

Finally, the inking rollers are removed from the plate and the dampening rollers are dropped on the plate. After 10 rotations the press is stopped and the dampening system is turned off.

A quotation of blinding is given by visual inspection of the plate; a score of 0 to 5 is given for the degree to which the image areas are covered with ink:
0 = image totally covered by ink;
1= image covered by ink for about 80%;
2= image covered by ink for about 60%;
3= image covered by ink for about 40%;
4= image covered by ink for about 20%;
5 = image where all ink is repelled.

The results of the blinding test are given in Table 7 below.

### 3. Stain evaluation.

The level of stain was determined after ageing the precursors during a period of 5 days at 80% humidity and a temperature of 20°C. The background stain level was evaluated on press by visual inspection after printing 250 pages.

Printing was performed by mounting the plates PP-01 to PP-07 on a Heidelberg GTO 46 printing press (available from Heidelberg). Each print job was started using K+E Novavit 800 Skinnex ink (trademark of BASF Druckfarben GmbH)and 2 wt% Prima FS404 (trademark of Agfa Graphics NV) in water as fountain solution. A compressible blanket was used and printing was performed on non-coated offset paper.

The results of staining are given in Table 7.

**Table 7: Gum solubility, blinding test and stain level**

| Printing plate | Gum solubility (presence of speckles)* | Blinding test* | Stain level |
|---|---|---|---|
| PP-01 | 5 | 1 | no stain |
| *Reference* | (yes) | | |
| PP-02 | 3 | 1 | no stain |
| *Inventive* | (no) | | |
| PP-03 | 3.5 | 1 | no stain |
| *Inventive* | (no) | | |
| PP-04 | 1.5 | 4 | black pages |
| *Comparative* | (no) | | |
| PP-06 | 1 | 5 | no stain |
| *Comparative* | (no) | | |

| | | | |
|---|---|---|---|
| *see above for test method and interpretation of values | | | |

The results show that the gum solubility of the inventive printing plates PP-02 and PP-03 including respectively Binder-01 and Binder-02 and the comparative printing plates PP-04 and PP-06 including respectively Binder-03 and Binder-05 is significantly improved over the reference printing plate PP-01.

The invention printing plates PP-02 and PP-03 including respectively Binder-01 and Binder-02 surprisingly show an excellent press behaviour in terms of blinding. The comparative printing plates PP-04 and PP-06 including respectively Binder-03 and Binder-05 show an unacceptable press behaviour in terms of blinding.

Furthermore, the printing plate PP-04 including Binder-03 shows an unacceptable high stain level (black pages).

### Example 2

### 1. Preparation of the printing plates PP-08 to PP-12

The printing plate precursors were prepared by coating onto the above described support S-01 the components as defined in Table 8 dissolved in a mixture of 40% by volume of MEK and 60% by volume of Dowanol PM (1-methoxy-2-propanol, commercially available from DOW CHEMICAL Company). The coating solution PL-02 was applied at a wet coating thickness of 30 µm and then dried at 120°C for 1 minute in a circulation oven.

**Table 8: Composition and dry coating weight of the photopolymerisable layer PL-02.**

| **INGREDIENT** (g/m²) | **PL-02 (thermal)** |
|---|---|
| IR dye (1) | 0.036 |
| Binder (2) | 0.225 |
| FST 426R (3) | 0.422 |
| CN-UVE 151M (4) | 0.422 |
| Tegoglide 410 (5) | 0.0023 |
| p-OH-TBMPS (6) | 0.09 |
| Pig-disp (7) | 0.18 |
| Sipomer PAM100 (8) | 0.195 |
| Albritect CP30 (9) | 0.036 |
| **Dry coating weight** | 1.6065 |

(1) IR dye is an infrared absorbing dye having the following structure : 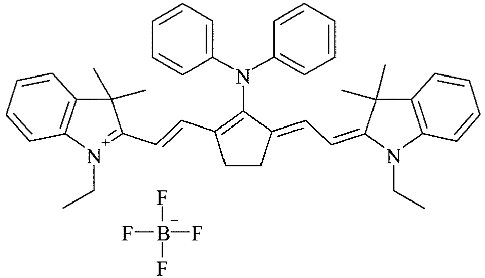
(2) See Table 9 below;
(3) See Table 4 above;
(4) CN-UVE 151M is an epoxy diacrylate monomer commercially available from Sartomer;
(5) See Table 4 above;
(6) p-OH-TBMPS is 4-hydroxyphenyl-tribromomethyl-sulfone 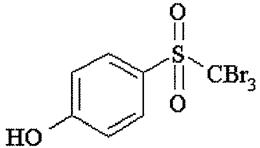
(7), (8) and (9) See Table 4 above.

### Imaging

The printing plate precursors were subsequently imaged at 2400 dpi with a Creo 3244T thermal platesetter (200 lpi Agfa Balanced Screening (ABS)), commercially available from Kodak and equipped with a 830 nm IR laser diode, at energy densities between 70 and 130 mJ/cm².

### Processing

After imaging, both the printing plate precursors were subjected to processing with VCF Gum NP (pH is 7 at room temperature, commercially available from Agfa Graphics NV) in a CRF45 processor™ (dwell time 30 s, at 21°C), available from Agfa Graphics NV, to remove the coating in the non-image areas from the support. This results in printing plates PP-08 to PP-12 (see Table 9).

**Table 9: printing plates and PP-08 to PP-12.**

| Printing plate | Binder* |
|---|---|
| PP-08 | Binder-ref |
| *reference* | Unmodified |
| PP-09 | Binder-01 |
| *inventive* | mercaptotetrazole |
| PP-10 | Binder-02 |
| *inventive* | mercaptotetrazole |
| PP-11 | Binder-03 |
| *comparative* | Carboxylic acid |
| PP-12 | Binder-05 |
| *comparative* | sulfonic acid |

| | |
|---|---|
| * Binder ref: S-Lec BX35Za polyvinylacetal bearing 14 mol% of free alcohol group supplied by SEKISUI; Binder-01 to Binder-06: synthesized as described above. | |

### Results

### 1. Gum solubility

The evaluation of the gum solubility is carried out as given in Example 1. The results of the gum solubility evaluation is given in Table 10 below.

### 2. Press behaviour in terms of blinding.

The test procedure as described in Example 1 was used to evaluate the press behaviour in terms of blinding. The results of the press behaviour is given in Table 10 below.

### 3. Stain evaluation.

The evaluation of the level of stain was determined according to the procedure given in Example 1. The results of the stain evaluation are given in Table 10 below.

**Table 10: Gum solubility, blinding test and stain level**

| Printing plate | Gum solubility, presence of speckles* | Blinding test* | Stain level |
|---|---|---|---|
| PP-08 | 5 | 1.5 | no stain |
| *Reference* | yes | | |
| PP-09 | 2 | 1.5 | no stain |
| *Inventive* | no | | |
| PP-10 | 3 | 1.5 | no stain |
| *inventive* | no | | |
| PP-11 | 1 | 3 | black pages |
| *comparative* | no | | |
| PP-12 | 1 | 5 | no stain |
| *comparative* | no | | |

The results in Table 10 show that the inventive printing plates PP-09 and PP-10 including respectively Binder-01 and Binder-02 surprisingly have an identical good press behaviour in terms of blinding as the reference printing plate PP-08. Comparative printing plate PP-11 and PP-12 including respectively Binder-03 and Binder-05 show an unacceptable blinding and comparative printing plate PP-11 additionally shows unacceptable staining.

The results further show that the comparative printing plates PP-11 and PP-12, and the inventive printing plates PP-09 and PP-10 have a significantly improved gum solubility compared to the the reference printing plate PP-08.

## Claims

1. A method for making a lithographic printing plate comprising the steps of:
a) providing a lithographic printing plate precursor comprising a support having a hydrophilic surface or which is provided with a hydrophilic layer, and a coating provided thereon, said coating including a photopolymerisable layer including a photopolymerisable composition,
b) image-wise exposing the precursor,
c) optionally heating the precursor,
d) developing the precursor by treating the precursor with a gum solution whereby the precursor is developed and gummed in one single step,
**characterized in that** the photopolymerisable composition comprises a compound including at least one moiety according to Formula (I) and/or Formula (II): 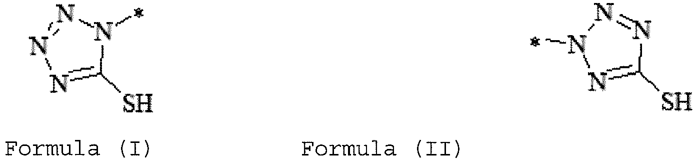 wherein *denotes the linking positions to the rest of the compound.

2. A method according to claim 1 wherein the compound is a monomer represented by Formula (III): 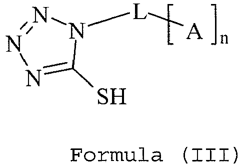 wherein
L represents a divalent, trivalent, tetravalent, pentavalent or hexavalent linking group;
A represents an ethylenically unsaturated group;
n represents 1, 2, 3, 4 or 5 respectively for a divalent, trivalent, tetravalent, pentavalent or hexavalent linking group L.

3. A method according to claim 2 wherein the monomer is represented by Formula (IV): 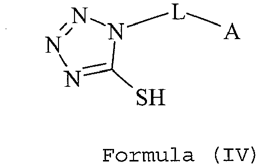 wherein
L represents a divalent linking group; and
A represent an ethylenically unsaturated group.

4. A method according to claim 1 wherein the compound is a polymer including at least one monomeric unit derived from the monomer according to Formula (IV): 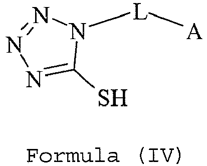 wherein
L represents a divalent linking group; and
A represent an ethylenically unsaturated group.

5. A method according to claim 4 wherein the polymer further comprises at least one monomeric unit according to Formula (V) : 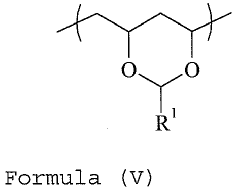 wherein R¹ represents an alkyl group.

6. A method according to any of the preceding claims 2 to 5
wherein the ethylenically unsaturated group is represented by an acrylate, methacrylate, acrylamide, methacrylamide, styrene, maleate, fumarate, itaconate, vinyl ether, vinyl ester, allyl ether and/or allyl ester group.

7. A method according to any of the preceding claims 2 to 6
wherein the ethylenically unsaturated group is represented by an acrylamide, methacrylamide or vinyl ester group.

8. A method any of the preceding claims 2 to 7 wherein L
represents an optionally substituted alkylene, cycloalkylene, arylene, or heteroarylene, -O-, -CO-, -CO-O-, -CO-NH-, -C<, >C<, -NH-CO-O-, -NH-CO-NH-, -NH-CS-NH-, -CO-NR'-, (CH₂-CH₂-O)ₑ-, -NH-CS-NH-, -SO-, -SO₂-, -SO₂-NH-, -CH=N-, -NH-NH-, - N⁺(CH₃)₂-, -S-, -S-S-, and/or combinations thereof, wherein e represents an integer greater than 1 and R' represents an optionally substituted alkylene, arylene, or heteroarylene.

9. A method any of the preceding claims 2 to 8 wherein L represents an optionally substituted alkylene group.

10. A method according to claims 4 or 5 wherein the polymer represents: 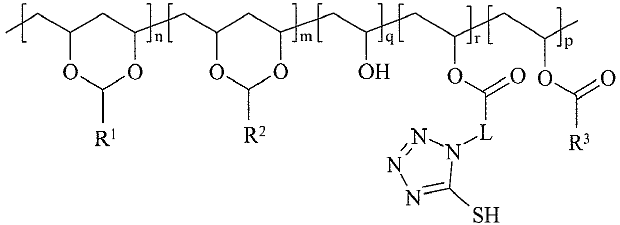
wherein R¹, R² and R³ independently represent an alkyl group;
n is in the range of 10 to 55 mol%;
m is in the range of 10 to 55 mol%;
q is in the range of 10 to 60 mol%;
r is in the range of 0.5 to 60 mol%; and
p is in the range of 0 to 10 mol%.

11. A method according to any of the preceding claims wherein the gum solution has a pH between 6 and 8.

12. A method according to any of the preceding claims wherein the gum solution includes a surface protective compound selected from a film-forming hydrophilic polymer or surfactant.

13. A method according to claim 12 wherein the gum solution remains on the plate after the developing step as a layer comprising 0.005 to 20 g/m² of the surface protective compound.

14. A method according to any of the preceding claims wherein the photopolymerisable composition further includes a polymerisable compound, a polymerization initiator and a binder.

15. A method according to any of the preceding claims wherein the method does not include a heating step and the support is grained and anodized aluminum without post-anodic treatment.

## Patentansprüche

1. Ein Verfahren zur Herstellung einer lithografischen Druckplatte, umfassend die folgenden Schritte:
a) Bereitstellen einer lithografischen Druckplattenvorstufe, umfassend einen Träger mit einer hydrophilen Oberfläche oder einen mit einer hydrophilen Schicht versehenen Träger und eine darüber aufgetragene Beschichtung, wobei die Beschichtung eine eine fotopolymerisierbare Zusammensetzung enthaltende fotopolymerisierbare Schicht enthält,
b) bildweises Belichten der Vorstufe,
c) gegebenenfalls Erwärmen der Vorstufe,
d) Entwicklung der Vorstufe durch Behandlung der Vorstufe mit einer Gummierlösung, wobei die Vorstufe in einem einzelnen Schritt entwickelt und gummiert wird,
**dadurch gekennzeichnet, dass** die fotopolymerisierbare Zusammensetzung eine Verbindung enthält, die mindestens einen Teil gemäß Formel (I) und/oder Formel (II) enthält: 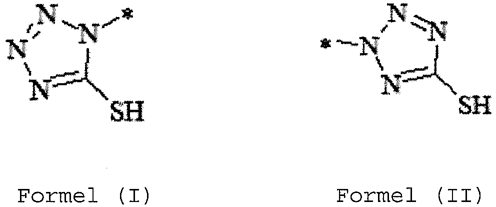 in denen * die Bindungsstellen an den Rest der Verbindung darstellt.

2. Ein Verfahren nach Anspruch 1, wobei die Verbindung ein durch Formel (III) dargestelltes Monomer ist: 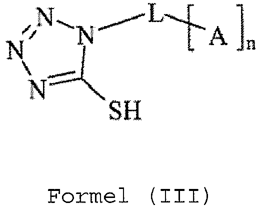 in der
L eine divalente, trivalente, tetravalente, pentavalente oder hexavalente Verbindungsgruppe darstellt,
A eine ethylenisch ungesättigte Gruppe darstellt,
n 1, 2, 3, 4 oder 5 für eine divalente, trivalente, tetravalente, pentavalente bzw. hexavalente Verbindungsgruppe L bedeutet.

3. Ein Verfahren nach Anspruch 2, wobei das Monomer durch Formel (IV) dargestellt wird: 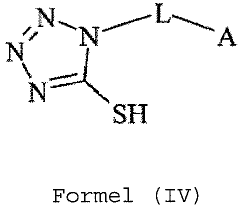 in der
L eine divalente Verbindungsgruppe darstellt, und
A eine ethylenisch ungesättigte Gruppe darstellt.

4. Ein Verfahren nach Anspruch 1, wobei die Verbindung ein Polymer ist, das mindestens eine vom Monomer gemäß Formel (IV) abgeleitete Monomereinheit umfasst: 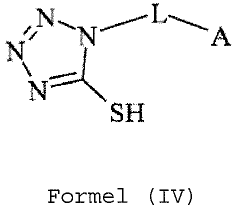 in der
L eine divalente Verbindungsgruppe darstellt, und
A eine ethylenisch ungesättigte Gruppe darstellt.

5. Ein Verfahren nach Anspruch 4, wobei das Polymer ferner mindestens eine Monomereinheit gemäß Formel (V) umfasst: 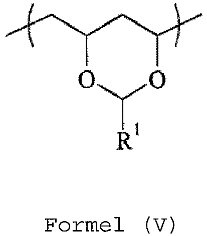 in der R¹ eine Alkylgruppe bedeutet.

6. Ein Verfahren nach einem der vorstehenden Ansprüche 2 bis 5, wobei die ethylenisch ungesättigte Gruppe durch eine Acrylat-, Methacrylat-, Acrylamid-, Methacrylamid-, Styrol-, Maleat-, Fumarat-, Itaconat-, Vinylether-, Vinylester-, Allylether- und/oder Allylestergruppe dargestellt wird.

7. Ein Verfahren nach einem der vorstehenden Ansprüche 2 bis 6, wobei die ethylenisch ungesättigte Gruppe durch eine Acrylamid-, Methacrylamid- oder Vinylestergruppe dargestellt wird.

8. Ein Verfahren nach einem der vorstehenden Ansprüche 2 bis 7, wobei L eine gegebenenfalls substituierte Alkylengruppe, Cycloalkylengruppe, Arylengruppe oder Heteroarylengruppe, -O-, -CO-, -CO-O-, -CO-NH-, -C<, >C<, -NH-CO-O-, -NH-CO-NH-, -NH-CS-NH-, -CO-NR'-, -(CH₂-CH₂-O)ₑ-, -NH-CS-NH-, -SO-, -SO₂-,-SO₂-NH- -CH=N-, -NH-NH-, -N⁺(CH₃)₂-, -S-, -S-S- und/oder Kombinationen derselben darstellt, wobei e eine ganze Zahl von mehr als 1 darstellt und R' eine gegebenenfalls substituierte Alkylengruppe, Arylengruppe oder Heteroarylengruppe darstellt.

9. Ein Verfahren nach einem der vorstehenden Ansprüche 2 bis 8, wobei L eine gegebenenfalls substituierte Alkylengruppe darstellt.

10. Ein Verfahren nach den Ansprüchen 4 oder 5, wobei das Polymer folgender Formel entspricht: 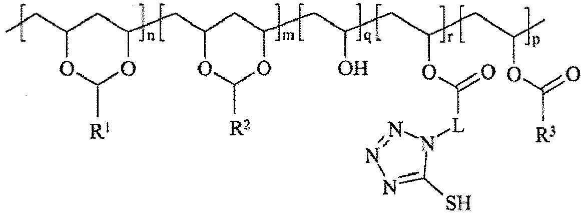
in der R¹, R² und R³ unabhängig voneinander eine Alkylgruppe darstellen,
n zwischen 10 und 55 mol-% liegt,
m zwischen 10 und 55 mol-% liegt,
q zwischen 10 und 60 mol-% liegt,
r zwischen 0,5 und 60 mol-% liegt, und
p zwischen 0 und 10 mol-% liegt.

11. Ein Verfahren nach einem der vorstehenden Ansprüche, wobei die Gummierlösung einen pH zwischen 6 und 8 aufweist.

12. Ein Verfahren nach einem der vorstehenden Ansprüche, wobei die Gummierlösung eine oberflächenschützende Verbindung, ausgewählt aus einem filmbildenden hydrophilen Polymer oder Tensid, enthält.

13. Ein Verfahren nach Anspruch 12, wobei die Gummierlösung anschließend an den Entwicklungsschritt als eine Schicht, die zwischen 0,005 und 20 g/m² der oberflächenschützenden Verbindung enthält, auf der Platte verbleibt.

14. Ein Verfahren nach einem der vorstehenden Ansprüche, wobei die fotopolymerisierbare Zusammensetzung ferner eine polymerisierbare Verbindung, einen Polymerisationshemmer und ein Bindemittel enthält.

15. Ein Verfahren nach einem der vorstehenden Ansprüche, wobei das Verfahren keinen Erwärmungsschritt umfasst und der Träger ein aufgerauter und anodisierter, keiner post-anodischen Behandlung unterzogener Aluminiumträger ist.

## Revendications

1. Procédé pour la confection d'une plaque d'impression lithographique, comprenant les étapes consistant à:
a) mettre à disposition un précurseur d'une plaque d'impression lithographique comprenant un support ayant une surface hydrophile ou un support revêtu d'une couche hydrophile et un revêtement appliqué sur ledit support, ledit revêtement comprenant une couche photopolymérisable contenant une composition photopolymérisable,
b) exposer sous forme d'image ledit précurseur,
c) le cas échéant, chauffer ledit précurseur,
d) développer ledit précurseur en le traitant avec une solution de gommage, ledit précurseur étant développé et gommé en une seule étape,
**caractérisé en ce que** la composition photopolymérisable contient un composé comprenant au moins une fraction répondant à la Formule (I) et/ou à la Formule (II): 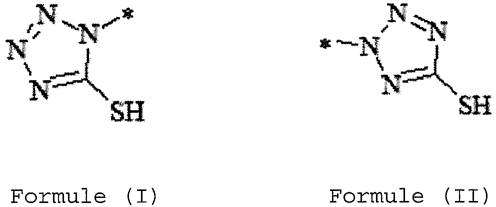 où * représente les sites de liaison au reste du composé.

2. Procédé selon la revendication 1, **caractérisé en ce que** le composé est un monomère représenté par la Formule (III): 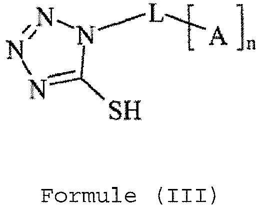 où
L représente un groupe de liaison divalent, trivalent, tétravalent, pentavalent ou hexavalent,
A représente un groupe éthyléniquement insaturé,
n représente 1, 2, 3, 4 ou 5 pour respectivement un groupe de liaison divalent, trivalent, tétravalent, pentavalent et hexavalent L.

3. Procédé selon la revendication 2, **caractérisé en ce que** le monomère est représenté par la Formule (IV): 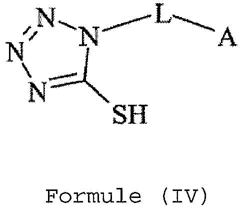 où
L représente un groupe de liaison divalent, et
A représente un groupe éthyléniquement insaturé.

4. Procédé selon la revendication 1, **caractérisé en ce que** le composé est un polymère comprenant au moins une unité monomère dérivée du monomère répondant à la Formule (IV): 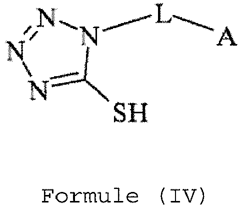 où
L représente un groupe de liaison divalent, et
A représente un groupe éthyléniquement insaturé.

5. Procédé selon la revendication 4, **caractérisé en ce que** ledit polymère comprend en outre au moins une unité monomère répondant à la Formule (V): 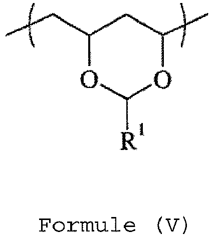 où R¹ représente un groupe alkyle.

6. Procédé selon l'une quelconque des revendications précédentes 2 à 5, **caractérisé en ce que** ledit groupe éthyléniquement insaturé est représenté par un groupe acrylate, méthacrylate, acrylamide, méthacrylamide, styrène, maléate, fumarate, itaconate, éther vinylique, ester vinylique, éther allylique et/ou ester allylique.

7. Procédé selon l'une quelconque des revendications précédentes 2 à 6, **caractérisé en ce que** ledit groupe éthyléniquement insaturé est représenté par un groupe acrylamide, méthacrylamide ou ester vinylique.

8. Procédé selon l'une quelconque des revendications précédentes 2 à 7, **caractérisé en ce que** L représente un groupe alkylène, cycloalkylène, arylène ou hétéroarylène éventuellement substitué, -O-, -CO-, -CO-O-, -CO-NH-, -C<, >C<, -NH-CO-O-, -NH-CO-NH-, -NH-CS-NH-, -CO-NR'-, -(CH₂-CH₂-O)ₑ-, -NH-CS-NH-, -SO-, -SO₂-, - SO₂-NH-, -CH=N-, -NH-NH-, -N⁺(CH₃)₂-, -S-, -S-S- et/ou des combinaisons de ceux-ci, e représentant un nombre entier supérieur à 1 et R' représentant un groupe alkylène, arylène ou hétéroarylène éventuellement substitué.

9. Procédé selon l'une quelconque des revendications précédentes 2 à 8, **caractérisé en ce que** L représente un groupe alkylène éventuellement substitué.

10. Procédé selon les revendications 4 ou 5, **caractérisé en ce que** ledit polymère répond à la formule suivante: 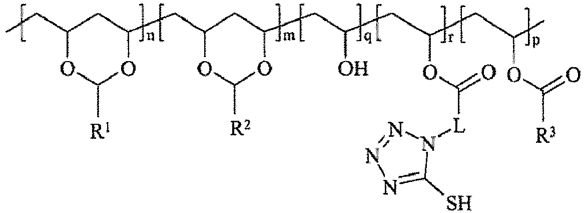
où R¹, R² et R³ représentent, indépendamment l'un de l'autre, un groupe alkyle,
n est compris entre 10 et 55 moles %,
m est compris entre 10 et 55 moles %,
q est compris entre 10 et 60 moles %,
r est compris entre 0,5 et 60 moles %, et
p est compris entre 0 et 10 moles %.

11. Procédé selon l'une quelconque des revendications précédentes, **caractérisé en ce que** la solution de gommage présente un pH compris entre 6 et 8.

12. Procédé selon l'une quelconque des revendications précédentes, **caractérisé en ce que** la solution de gommage contient un composé protecteur de surface choisi parmi un polymère ou agent tensioactif hydrophile filmogène.

13. Procédé selon la revendication 12, **caractérisé en ce que**, à l'issue de l'étape de développement, la solution de gommage demeure sur la plaque sous forme de couche contenant entre 0,005 et 20 g/m² dudit composé protecteur de surface.

14. Procédé selon l'une quelconque des revendications précédentes, **caractérisé en ce que** la composition photopolymérisable contient en outre un composé polymérisable, un inhibiteur de polymérisation et un liant.

15. Procédé selon l'une quelconque des revendications précédentes, **caractérisé en ce que** le procédé ne comprend pas d'étape de chauffage et que le support est un support grainé et anodisé qui n'a pas été soumis à un traitement post-anodique.
